# EUROPÄISCHE PATENTANMELDUNG

(11) **EP 0 735 808 A1**
(43) Veröffentlichungstag der Anmeldung: **02.10.1996**
(21) Anmeldenummer: 95115122.4
(22) Anmeldetag: 26.09.1995
(51) Int. Cl.: H05K 3/34

(54) **SMD-Verbindung für elektronische Steuergeräte in Kraftfahrzeugen**

(30) Priorität: 27.03.1995 DE 19511226
(71) Anmelder: ROBERT BOSCH GMBH, 70442 Stuttgart (DE)
(72) Erfinder: Schaefer, Ulrich, Dr. Physiker, D-72800 Eningen (DE); Jares, Peter, Dipl.-Ing., D-71069 Sindelfingen (DE); Jessberger, Thomas, D-71277 Rutesheim (DE); Karr, Dieter, Dipl.-Physiker, D-75233 Tiefenbronn (DE)

(57) **Zusammenfassung**

Es wird eine SMD-Verbindung für elektronische Steuergeräte vorgeschlagen, bei der eine Lötverbindung zwischen Steckerleiste und einer Leiterplatte (1) zwischen Steckerpins (3, 4) der Steckerleiste und Bohrungen (2) der Leiterplatte (1) hergestellt wird.

Dabei wird eine Lotpaste (5) entweder als Scheibe (6) auf die Leiterplatte (1) über der Bohrung (2) aufgedruckt und beim Steckvorgang durch die Steckerpins (3, 4) in die Bohrungen (2) hineingedrückt, oder es wird Lotpaste (5) nach dem Bestücken der Steckerleiste von unten in die Bohrungen (2) der Leiterplatte (1) mittels eines Dispensers (9) eingebracht.

In einem Reflow-Ofen wird anschließend die Lötpaste (5) aufgeschmolzen und damit eine zuverlässige Kontaktierung zwischen der Steckerleiste und den von der Leiterplatte (1) getragenen Kontaktelementen erreicht. Eine Plazierung von Leistungs-Endstufen (12) und von IC-Bauteilen (11) ist damit auch auf der Leiterplattenunterseite möglich.

Die SMD-Verbindung ist bestimmt für elektronische Steuergeräte in Kraftfahrzeugen.

## Beschreibung

### Stand der Technik

Die Erfindung geht aus von einer SMD-Verbindung für elektronische Steuergeräte in Kraftfahrzeugen nach der Gattung des Hauptanspruchs.

Der Funktionsumfang solcher elektronischen Steuergeräte wird ständig erweitert. Mit größer werdendem Funktionsumfang nehmen die Anzahl und damit die Packungsdichte der auf Leiterplatten des Steuergeräts montierten elektronischen Kontaktelemente zu. Heute sind die Leiterplatten üblicherweise in SMD-Technik (Surface Mounted Devices) bestückt. Dabei werden die Kontaktelemente mit ihren Anschlußabschnitten auf spezielle, mit einer aufgedruckten Lotpaste versehene Anschlußflächen der Leiterplatte aufgesetzt und durch eine Reflow-Lötung, bei der die Lotpaste durch Hitzeeinwirkung fließfähig gemacht wird, mit den Anschlußflächen stoffschlüssig verbunden. Solche Verbindungen neigen aber infolge der geringen Festigkeit des Lots dazu, bei mechanischen Belastungen nachzugeben und zu Funktionsausfällen zu führen.

Der Erfindung liegt die Aufgabe zugrunde, diesen Nachteil zu vermeiden und eine SMD-Verbindung der eingangs genannten Art zu schaffen, bei der die Steckerpins der Steckerleiste von Bohrungen aufgenommen werden und mit der Bohrungswand in einfacher Löttechnik zuverlässig verbindbar sind.

Diese Aufgabe wird gemäß der Erfindung gelöst durch die kennzeichnenden Merkmale des Hauptanspruchs.

Vorteilhafte Weiterbildungen des Anspruchsgegenstandes werden durch die Merkmale der Unteransprüche erreicht. So ist es z. B. vorteilhaft, vor dem Bestücken der Steckerleiste die Lotpaste als Scheibe auf die Leiterplatte aufzubringen, vorzugsweise aufzudrucken, und die Lotpaste dann mit Hilfe der Steckerpins in die Bohrungen der Leiterplatte um ein definiertes Maß einzudrücken. Auf diese Weise ist sichergestellt, daß für jede Steckverbindung eine einwandfreie Lötverbindung gewährleistende genügende Menge Lot zur Verfügung steht.

Es ist außerdem auch möglich, die Lotpasten-Scheibe durch Lotpasten-Bällchen zu ersetzen, die meist in ihrer Mitte ein Loch aufweisen.

Gemäß einem weiteren Merkmal der Unteransprüche wird die Unterseite der Leiterplatte mit einem Lötstop-Lack versehen. Das hat den Vorteil, daß das für eine Verbindung bestimmte Lot im Reflow-Prozeß nicht nach unten aus der Bohrung auslaufen kann.

Schließlich ist gemäß einem weiteren Merkmal der Unteransprüche auch die Alternative möglich, das Lot nach dem Bestücken der Steckerleiste von der Unterseite der Leiterplatte mittels Dispenser einzubringen. Ein solches Verfahren gestattet es, auch bei mit anderen Lötmethoden nicht doppelseitig an einer Leiterplatte anzubringenden Bauelementen, wie Leistungsendstufen und IC-Bauteile, diese an der Unterseite der Leiterplatte zu befestigen. Damit ist dann eine Verdoppelung der plazierbaren Bauelemente bzw. eine Ersparnis an Leiterplattenfläche möglich. Durch sehr kurze Verbindungswege ist eine Verbesserung der Kontaktierung, z. B. eine Durchkontaktierung, zu erreichen.

Beide beschriebene Lotverbindungsarten, die Eindrückverbindung und die mittels Dispenser, ermöglichen ein Aufschmelzen des Lots in einem Reflow-Ofen, wobei die zum Schmelzen des Lots notwendige Erwärmung mittels Infrarotstrahler oder mittels einer Rotlichtlampe erreicht wird.

### Zeichnung

Mehrere Ausführungsbeispiele der Erfindung sind in der Zeichnung dargestellt und in der nachfolgenden Beschreibung näher erläutert. Es zeigen: Figuren 1 und 2 eine auf eine Leiterplatte aufgedruckte Scheibe im Ausgangs- und im Prägezustand, Figur 3 die fertig verlötete Verbindung, Figur 4 eine mittels Dispenser durchgeführte Lötverbindung und Figur 5 die Plazierung der Kontaktelemente auf der Leiterplatte.

### Beschreibung der Ausführungsbeispiele

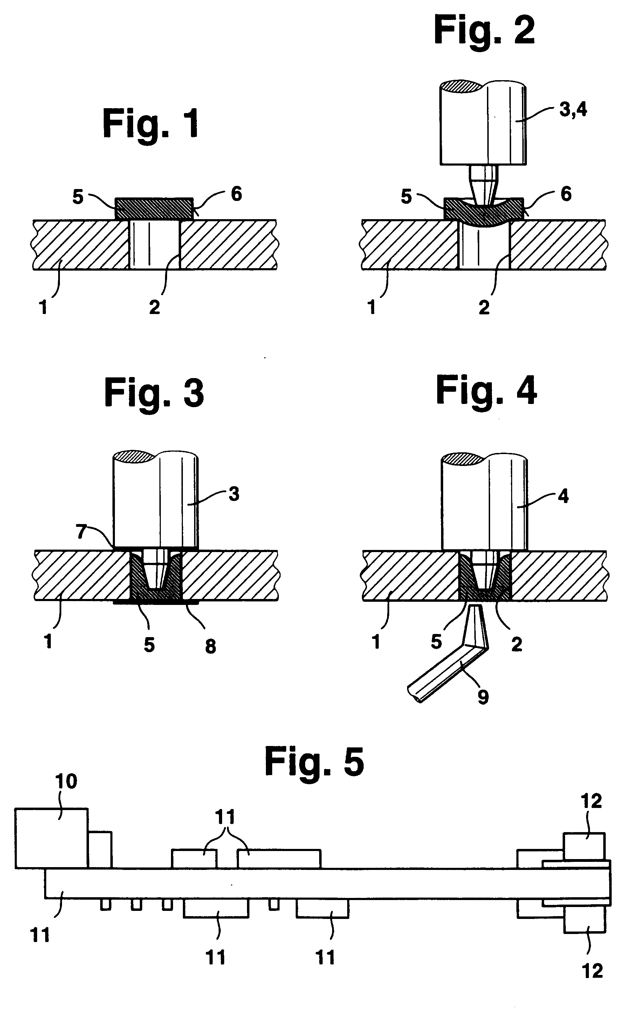

Eine Leiterplatte 1 ist mit einer Anzahl von Bohrungen versehen, von denen nur eine Bohrung 2 dargestellt ist. Die Leiterplatte 1 ist dazu bestimmt, mit einer nicht dargestellten Steckerleiste bestückt zu werden. Diese Steckerleiste ist mit Steckerpins versehen, von denen in den Figuren 3 und 4 jeweils ein Steckerpin 3 bzw. 4 dargestellt ist. Solche Steckerleisten werden in der Praxis auch als Messerleisten bezeichnet.

Vor dem Bestücken der Steckerleiste wird in einem Standard-Arbeitsgang die Lotpaste 5 in Form einer Scheibe 6 auf die Leiterplatte 1 über die Bohrung 2 aufgedruckt. Wenn nun die Steckerleiste auf die Leiterplatte 1 aufgesetzt wird, drückt der Steckerpin 3 bzw. 4 die Lotpasten-Scheibe 6 in die Bohrung 2 hinein. Eine erste Phase des Hineindrückens ist in der Figur 2 dargestellt.

Die Figur 3 zeigt den Endzustand des Hineindrückens der Scheibe 6 in die Bohrung 2. Der Steckerpin 3 hat eine schulterförmige Auflage-Ringfläche 7, die verhindert, daß der Steckerpin 3 zu weit in die Bohrung 2 eindringt und dabei unten aus der Bohrung 2 heraustritt und gegebenenfalls die Lotpaste 5 unten aus der Bohrung 2 herausdrückt. Um aber auch bei einem definierten Tiefen-Anschlag des Steckerpins 3 ein Hinausdrücken von Lotpaste 5 aus der Bohrung 2 zu verhindern, ist die Bohrung 2 zusätzlich an ihrer unteren Ausmündung mit einem Lötstop-Lack 8 verschlossen. Auf diese Weise ist erreicht, daß auf jeden Fall genügend Lotpaste 5 für eine einwandfreie Lötverbindung zur Verfügung steht.

In einem mit Infrarot oder einer Rotlichtlampe ausgerüsteten Reflow-Ofen wird nun die Lotpaste 5 auf Schmelztemperatur erwärmt, so daß eine einwandfreie Lötverbindung zwischem dem Steckerpin der Steckerleiste und der Wand der Bohrung 2 der Leiterplatte entsteht.

Die Figur 4 zeigt, daß es auch im Rahmen der Erfindung liegt, die Lotpaste 5 auf andere Weise in die Bohrung 2 einzubringen. Und zwar wird hier die Lotpaste 5 nach dem Bestücken der Steckerleiste, also nach dem Eindringen des Steckerpins 4 in die Bohrung 2, mit Hilfe eines Dispensers 9 von unten in die Bohrung 2 eingebracht. Ein Dispenser ist ein mit einem düsenförmigen Endstück versehenes Zuführelement für fließfähige Stoffe, wie beispielsweise Lotpaste, mit dem diese Stoffe in kleinen Mengen und in eng begrenzten Bereichen ausgebracht werden können.

Danach wird dann auch diese Verbindung in einem Reflow-Ofen erwärmt und dadurch verlötet. Auf diese Weise ist dann ebenfalls gewährleistet, daß für eine zuverlässige Verbindung eine ausreichende Menge von Lotpaste 5 zur Verfügung steht.

Die Figur 5 läßt erkennen, daß die erfindungsgemäße SMD-Verbindung es gestattet, Kontaktelemente sowie Leistungs-Endstufen 12 und IC-Bauteile 11 nicht nur an der Oberseite, sondern auch an der Unterseite der Leiterplatte, die einen Reflow-Stecker 10 trägt, zu befestigen. Eine Verdoppelung der plazierbaren Kontaktelemente 11 und 12 ist damit ohne weiteres möglich. Durch die sehr kurzen Verbindungswege sind eine Verbesserung der Kontaktierung auf der Leiterplatte 1 und sogar eine Durchkontaktierung zu erreichen, was eine Ersparnis an Filtermaßnahmen wie Filter-Kondensatoren und Schirmblechen mit sich bringt. Schließlich können bei der erfindungsgemäßen Verbindung kleinere, leichtere Steuergeräte verwendet werden.

## Patentansprüche

1. SMD-Verbindung für elektronische Steuergeräte in Kraftfahrzeugen mit in einem Isolierkörper angeordneten Kontaktelementen, deren Anschlußabschnitte mit Anschlüssen verbindbar sind, die auf einer Leiterplatte angebracht sind, mit mit Bohrungen und mit Ablageflächen für die Lotpaste versehen ist, dadurch gekennzeichnet, daß zum Herstellen der Verbindung auf der Oberseite und auf der Unterseite der Leiterplatte (1) ein Reflow-Lötprozeß eingesetzt wird.

2. SMD-Verbindung nach Anspruch 1, dadurch gekennzeichnet, daß zum Herstellen der Verbindung auf der Oberseite und auf der Unterseite der Leiterplatte (1) ein einziger Reflow-Lötprozeß eingesetzt wird.

3. SMD-Verbindung nach Anspruch 1 oder 2, dadurch gekennzeichnet, daß Kontaktelemente sowie Leistungsendstufen (12) und/oder IC-Bauteile (11) auf beiden Seiten der Leiterplatte (1) plazierbar sind.

4. SMD-Verbindung nach einem der Ansprüche 1 bis 3, dadurch gekennzeichnet, daß Ablageflächen für die Lotpaste (5) im Bereich der Bohrungen (2) vorgesehen sind, daß eine Steckerleiste mit Steckerpins (3, 4) versehen ist, die zum Einstecken in die Bohrungen (2) bestimmt sind, und daß eine Löt-Verbindung zwischen den Steckerpins (3, 4) und den Wandungen der Bohrungen (2) in einem Infrarot-Reflow-Ofen herstellbar ist.

5. SMD-Verbindung nach Anspruch 4, dadurch gekennzeichnet, daß die Lotpaste (5) als Scheibe (6) auf die Leiterplatte (1) aufdruckbar ist und daß die scheibenförmige Lotpaste (5) beim Aufsetzen der Steckerleiste durch die Steckerpins (3, 4) in die Bohrungen (2) eindrückbar ist.

6. SMD-Verbindung nach Anspruch 4 oder 5, dadurch gekennzeichnet, daß die Steckerpins (3, 4) eine schulterförmige Auflage-Ringfläche (7) zur Begrenzung der Eindringtiefe der Steckerpins (3, 4) in die Bohrungen (2) aufweisen.

7. SMD-Verbindung nach einem der Ansprüche 4 bis 6, dadurch gekennzeichnet, daß auf der Unterseite der Leiterplatte (1) im Bereich der Ausmündungen der Bohrungen (2) ein Lötstop-Lack (8) aufgebracht ist.

8. SMD-Verbindung nach einem der Ansprüche 1 bis 7, dadurch gekennzeichnet, daß die Lotpaste (5) von der Unterseite der Leiterplatte (1) her in die Bohrungen (2) mittels eines Dispensers (9) einbringbar ist.
